# EUROPÄISCHE PATENTSCHRIFT

(11) **EP 0 934 605 B1**
(45) Veröffentlichungstag und Bekanntmachung des Hinweises auf die Patenterteilung: **17.11.2004**
(21) Anmeldenummer: 97909173.3
(22) Anmeldetag: 22.09.1997
(51) Int. Cl.: H01L 41/04

(54) **VERFAHREN UND VORRICHTUNG ZUM ANSTEUERN EINES KAPAZITIVEN STELLGLIEDES**
METHOD AND DEVICE FOR CONTROLLING A CAPACITATIVE ACTUATOR
PROCEDE ET DISPOSITIF POUR COMMANDER UN ACTIONNEUR CAPACITIF

(30) Priorität: 25.10.1996 DE 19644521
(43) Veröffentlichungstag der Anmeldung: 11.08.1999
(73) Patentinhaber: SIEMENS AKTIENGESELLSCHAFT, 80333 München (DE)
(72) Erfinder: HOFFMANN, Christian, D-93057 Regensburg (DE); FREUDENBERG, Hellmut, D-93080 Pentling (DE); GERKEN, Hartmut, D-93152 Nittendorf (DE)
(86) Internationale Anmeldenummer: PCT/DE1997/002151
(87) Internationale Veröffentlichungsnummer: WO 1998/019346

(56) Entgegenhaltungen:
- US-A- 5 479 062
- US-A- 5 543 679
- PATENT ABSTRACTS OF JAPAN vol. 012, no. 489 (E-696), 21.Dezember 1988 & JP 63 204674 A (BROTHER IND LTD), 24.August 1988,
- PATENT ABSTRACTS OF JAPAN vol. 012, no. 064 (M-672), 26.Februar 1988 & JP 62 210241 A (NIPPON DENSO CO LTD;OTHERS: 01), 16.September 1987,
- PATENT ABSTRACTS OF JAPAN vol. 018, no. 447 (E-1594), 19.August 1994 & JP 06 140682 A (TOYOTA MOTOR CORP), 20.Mai 1994,
- PATENT ABSTRACTS OF JAPAN vol. 018, no. 188 (E-1532), 31.März 1994 & JP 05 344755 A (TOYOTA MOTOR CORP), 24.Dezember 1993,

## Beschreibung

Die Erfindung betrifft ein Verfahren und eine Vorrichtung zum Ansteuern eines kapazitiven Stellgliedes, insbesondere eines piezoelektrisch betriebenen Kraftstoffeinspritzventils einer Brennkraftmaschine.

Piezo-Stellglieder bestehen aus einer Vielzahl piezokeramischer Schichten und bilden einen sog. "Stack", der bei Anlegen einer Spannung seine Abmessungen, insbesondere seine Länge s um einen Hub ds verändert, oder bei mechanischem Druck oder Zug eine elektrische Spannung erzeugt.

Es sind unterschiedliche Verfahren zur Ansteuerung von Piezo-Stellgliedern, die sich elektrisch wie Kondensatoren verhalten, bekannt, bei denen die am Piezostellglied anliegende Spannung überwacht wird. Als Kriterium für das Beenden der Aufladung wird bei allen bekannten Verfahren das Erreichen einer bestimmten Spannung am Piezostellglied herangezogen, sofern keine aufwendige Messung für den erreichten Stellglied-Hub ds vorgesehen ist. Ein Beispiel dafür ist die ältere deutsche Patentanmeldung 1932872.1.

Die elektrischen Eigenschaften eines derartigen Piezostacks ändern sich mit der Temperatur, der er ausgesetzt ist. Mit steigender Temperatur vergrößert sich seine Kapazität, aber auch der Hub nimmt zu. Bei den für automotive Anwendungen zu berücksichtigenden Temperaturen von etwa -40°C bis +150°C sind dabei Änderungen bis zu einem Faktor 2 zu beobachten.

Wird ein Piezo-Stellglied in allen Betriebspunkten beispielsweise auf eine konstante Spannung aufgeladen, die bei niedrigen Temperaturen den benötigten Hub ds erbringt, so erhält man bei hohen Temperaturen einen Hub, der deutlich größer ist als erforderlich - was bei Kraftstoffeinspritzventilen mit konstantem Kraftstoffdruck eine zu große Kraftstoffmenge bedeutet, oder umgekehrt. Da bei hohen Temperaturen die Kapazität des Piezostacks ebenfalls größer ist, wird sehr viel mehr Ladung und Energie (E = ½^{·} C^{·} U ) benötigt, als erforderlich.

Aus US 5,387,834 ist eine Ansteuerschaltung für ein piezoelektrisches Element eines Matrix-Druckers bekannt, bei welcher ein Temperatursensor die Temperatur des piezoelektrischen Elements fühlt. Die Ansteuerung des piezoelektrischen Elements erfolgt mit Ladezeiten, welche temperaturabhängig in einer Tabelle gespeichert sind.

Aus US 5,543,679 ist eine Ansteuerschaltung für ein piezoelektrisches Element zum Betreiben eines Kraftstoffventils bekannt, bei der von einem Kondensator eine vermeintlich konstante Ladung entnommen und über einen Übertrager dem piezoelektrischen Element zugeführt wird. Alle Änderungen der Schaltung infolge Änderungen von Temperatur, Luftfeuchte, Bauteiletoleranzen, Alterung u.s.w. bleiben dabei unberücksichtigt.

In Patent Abstracts of Japan, vol 018, no. 188(E-1532), 31. März 1994&JP-A 05 344755 ist eine Ansteuerschaltung für ein piezoelektrisches Element zum Betreiben eines Kraftstoffventils offenbart, bei welcher das piezoelektrische Element über eine erste geregelte Spannung mit konstanter Lademenge geladen und über eine Kapazitätsbestimmung des piezoelektrischen Elements aus der beim Entladen gemessenen Spannung auf eine geregelte zweite, negative Spannung wieder vollständig entladen wird.

Es ist Aufgabe der Erfindung, die Ansteuerung eines kapazitiven Stellgliedes, ohne einen Temperatursensor zu verwenden, derart durchzuführen, daß im gesamten Temperaturbereich, in welchem das Stellglied betrieben wird, ein möglichst konstanter Hub ds erreicht wird. Aufgabe der Erfindung ist auch, eine Vorrichtung zur Durchführung dieses Verfahrens zu schaffen.

Diese Aufgabe wird erfindungsgemäß durch die in einem der Ansprüche 1 oder 2 genannten Merkmale gelöst. Entsprechende Vorrichtungen sind in den Ansprüchen 3 und 4 angegeben.

Untersuchungen haben gezeigt, daß die einem kapazitiven Stellglied zugeführte Energie ein sehr viel präziseres Maß für den Hub ds darstellt als die angelegte Spannung, und daß eine Aufladung mit konstanter Energie über den benötigten Temperaturbereich einen wesentlich konstanteren Hub erbringt. Der Hub ändert sich etwa linear mit der angelegten Spannung bei einer bestimmten Temperatur. Ändert sich die Temperatur, so ändert sich auch der Hub bei gleichbleibender Spannung. Hingegen ändert sich der Hub proportional zum Quadrat der aufgebrachten Energie (ds ≈ e²), jedoch unabhängig von der Temperatur.

Bei der großserienmäßigen Herstellung von Piezostacks ist die Schichtdicke der einzelnen Piezoschichten nicht exakt gleich. Man kann beispielsweise Stacks mit konstanter Länge s, aber unterschiedlicher Anzahl der Schichten herstellen. Solch unterschiedliche Stacks gelangen dann auch zum Einsatz, wenn ein defektes Kraftstoffventil durch ein anderes ersetzt wird. Bei der Aufladung solch unterschiedlicher Stacks mit konstanter Spannung ergeben sich bereits bei gleicher Temperatur unterschiedliche Hübe ds.

Ein Vorteil des erfindungsgemäßen Ansteuerverfahrens ist, daß bei Ladung eines Stellgliedes mit konstanter Energie solche unterschiedlichen Stacks nicht nur bei einer bestimmten Temperatur, sondern auch über den gesamten, oben bezifferten Temperaturbereich einen nahezu gleichen, konstanten Hub ds aufweisen.

Ein weiterer Vorteil des erfindungsgemäßen Ansteuerverfahrens ist, daß durch Erfassung der dem Stellglied zugeführten Energie - nicht der einer Versorgungsquelle oder einem Kondensator entnommenen Ladung - alle Änderungen der Schaltung infolge Änderungen von Temperatur, Luftfeuchte, Bauteiletoleranzen, Alterung u.s.w. bei der Messung bzw. Zumessung der Energie berücksichtigt werden.

Zwei Ausführungsbeispiele zur Ansteuerung eines kapazitiven Stellgliedes (Piezistellgliedes) zur Betätigung eines Kraftstoffeinspritzventils einer Brennkraftmaschine werden nachstehend anhand der Zeichnung näher erläutert. Es zeigen:
- Figur 1:: ein schematisches Schaltbild eines ersten Ausführungsbeispiels,
- Figur 2:: ein schematisches Schaltbild eines zweiten Ausführungsbeispiels, und
- Figur 3:: ein Flußdiagramm, betreffend die Arbeitsweise der Schaltungen nach Figur 1 und 2.

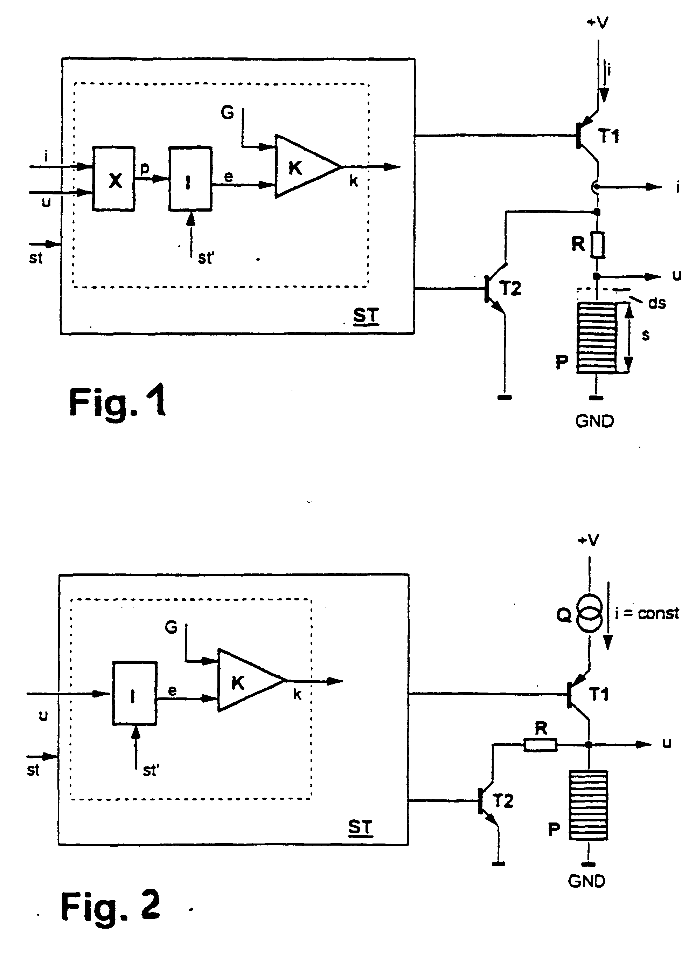

Figur 1 zeigt ein erstes Ausführungsbeispiel zum Ansteuern eines Piezostellgliedes P eines nicht dargestellten Kraftstoffeinspritzventils einer Brennkraftmaschine mittels einer üblicherweise mikroprozessorgesteuerten Steuerschaltung ST.

Zwischen dem Pluspol +V und dem Minuspol GND einer Energiequelle V liegt eine Reihenschaltung aus einem von der Steuerschaltung ST gesteuerten, elektronischen Schalter T1, aus einem strombegrenzenden Element, beispielsweise einem Widerstand R (oder einer Spule) und aus einem Piezostellglied P des Kraftstoffeinspritzventils mit der Länge s. Parallel zur Reihenschaltung aus Piezostellglied P und Widerstand R ist ein weiterer elektronischer Schalter T2 angeordnet.

Die elektronischen Transistorschalter T1 und T2 werden von der Steuerschaltung ST angesteuert, die ein externes Steuersignal st für die Einspritzdauer, beispielsweise von einem Motorsteuergerät (in welchem auch die Steuerschaltung integriert sein kann) erhält. Des weiteren werden bei leitend geschaltetem Schalter T1 der in das Piezostellglied P fließende, durch den Widerstand R begrenzte Strom i und die am Piezostellglied P abfallende Spannung u gemessen und der Steuerschaltung ST als weitere Eingangsgrößen zugeführt.

In der Steuerschaltung ST sind - strichliert umrandet - ein Multiplizierglied X, ein Integrator I und ein Komparator K in Reihe hintereinander angeordnet, wobei der Ausgang des Multipliziergliedes X mit dem Eingang des Integrators I und dessen Ausgang mit einem Eingang des Komparators K verbunden ist. Dem anderen Eingang des Komparators K wird ein Sollwert G für die gewünschte Energiemenge zugeführt.

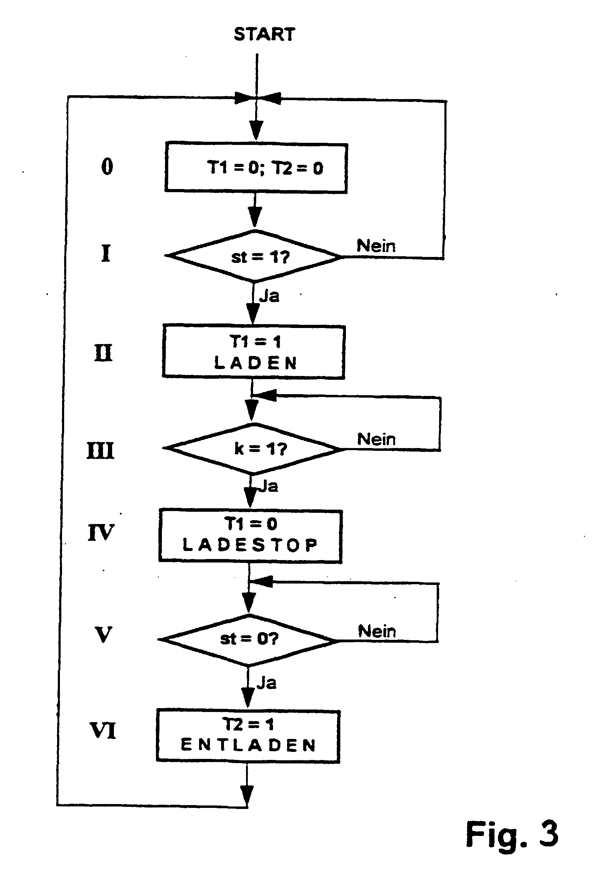

Anhand des in Figur 3 gezeigten Flußdiagramms wird ein Verfahren zum Betreiben der Schaltung nach Figur 3 beschrieben, welches auch auf die weiter unten beschriebene Schaltung nach Figur 2 anwendbar ist, ausgehend von einem Anfangszustand (Zustand 0), in welchem beide Schalter T1 und T2 nichtleitend sind. T1 = 0 bedeutet nichtleitend; T1 = 1 bedeutet leitend. Dasselbe gilt für T2. Für die Signale st und k gilt: "1" bedeutet vorhanden, "0" bedeutet nicht vorhanden.

Mit dem Beginn eines Steuersignals st, welches von 0 nach 1 wechselt (Zustand I), wird der Schalter T1 stromleitend gesteuert. Damit beginnt ein durch den Widerstand R begrenzter Strom i vom Pluspol +V der Spannungsquelle über den Schalter T1 und das Piezostellglied P zum Minuspol GND zu fließen. Am Piezostellglied P baut sich die Spannung u auf: das Piezostellglied dehnt sich um den Hub ds auf die Länge ṡ + ds aus und öffnet das Einspritzventil (Zustand II), so daß Kraftstoff eingespritzt wird. Von der Anfangsflanke st' des Steuersignals st angestoßen, wird gleichzeitig der Integrator I entladen. Zu Beginn jedes Einspritzvorgangs ist demnach dessen Ausgangssignal e = 0.

Die der Steuerschaltung ST zugeführten Meßgrößen i und u werden im Multiplizierglied X miteinander multipliziert und das an seinem Ausgang erscheinende Produkt p anschließend im eben entladenen Integrator I aufintegriert. Das Ausgangssignal e des Integrators I ist proportional zu der dem Piezostellglied P zugeführten Energie e = ∫uidt und wird dem Komparator K zugeführt, in welchem es mit einem Sollwert G verglichen wird. Sobald es diesen Sollwert erreicht oder übersteigt, gibt der Komparator ein digitales Ausgangssignal k = 1 ab (Zustand III). Durch dieses Komparatorausgangssignal k = 1 wird die Steuerschaltung ST veranlaßt, den Schalter T1 nichtleitend zu steuern (Zustand IV), wodurch der Ladevorgang des Piezostellgliedes P beendet ist.

Das Stellglied hat den gewünschten Hub ds erreicht und damit das Kraftstoffeinspritzventil die gewünschte Öffnung, wodurch infolge konstanten Kraftstoffdrucks die eingespritzte Kraftstoffmenge proportional zur Öffnungsdauer des Stellgliedes ist. Das Kraftstoffeinspritzventil bleibt mit dem der aufgebrachten Energie e zugeordneten Hub ds solange geöffnet, bis das Steuersignal st verschwindet, st = 0 (Zustand V).

Wird das Steuersignal st = 0, wird von der Steuerschaltung ST der Schalter T2 leitend gesteuert (Zustand VI), wodurch das Piezostellglied über den Widerstand R entladen wird und das Kraftstoffeinspritzventil schließt. Damit ist der Einspritzvorgang beendet. Der nächste und alle weiteren Einspritzvorgänge werden in der gleichen Weise durchgeführt.

Figur 2 zeigt ein einfacheres Ausführungsbeispiel der erfindungsgemäßen Schaltung mit einer Abänderung gegenüber der Schaltung nach Figur 1, dahingehend, daß in den Ladestrompfad des Piezostellgliedes P eine Konstantstromquelle Q eingefügt ist, von der das Piezostellglied P mit einem konstanten Strom i = const geladen wird. Infolge der bekannten Stromstärke kann die Strommessung entfallen und damit auch die aufwendig durchzuführende Multiplikation u*i, sowie das Multiplizierglied X. Die neben dem Steuersignal st einzige Eingangsgröße u der Steuerschaltung ST wird dem Integrator I zugeführt, dessen Ausgangssignal e proportional der eingespeisten Energie ist. Die weitere Funktion der Schaltung entspricht derjenigen nach Figur 1. Der Widerstand bzw. das strombegrenzende Element ist hier lediglich zur Begrenzung des Entladestromes erforderlich und ist deshalb zwischen Piezostellglied P und Schalter T2 angeordnet.

## Patentansprüche

1. Verfahren zum Ansteuern eines kapazitiven Stellgliedes (P), insbesondere eines piezoelektrisch betriebenen Kraftstoffeinspritzventils einer Brennkraftmaschine, mit einer vorgegebenen, einem bestimmten Stellgliedhub (ds) zugeordneten Energiemenge (e),
**dadurch gekennzeichnet,**
**daß** während des Aufladevorgangs des Stellgliedes (P) aus einer Energiequelle (V) der'in das Stellglied (P) fließende Strom (i) und die am Stellglied (P) abgreifbare Spannung (u) miteinander multipliziert werden,
**daß** das Produkt (p = ui) von Strom (i) und Spannung (u) über der Zeit integriert wird (e = ∫uidt), und
**daß** der Aufladevorgang beendet ist, wenn der Integralwert (e) einen vorgegebenen Sollwert (G) erreicht oder übersteigt.

2. Verfahren zum Ansteuern eines kapazitiven Stellgliedes (P), insbesondere eines piezoelektrisch betriebenen Kraftstoffeinspritzventils einer Brennkraftmaschine, mit einer vorgegebenen, einem bestimmten Stellgliedhub (ds) zugeordneten Energiemenge (e),
**dadurch gekennzeichnet,**
**daß** das Stellglied (P) mit einem vorgegebenen Konstantstrom (i = const) aufgeladen wird,
**daß** die am Stellglied (P) abgreifbare Spannung (u) während
des Ladevorgangs über der Zeit integriert wird (e = ∫udt), und
**daß** der Aufladevorgang beendet ist, wenn der Integralwert (e)
einen vorgegebenen Sollwert (G) erreicht oder übersteigt.

3. Vorrichtung zur Durchführung des Verfahrens nach Anspruch 1, mit einer zwischen dem Pluspol (+V) und dem Minuspol (GND) einer Spannungsquelle (V) angeordneten Reihenschaltung aus dem Stellglied (P), einem strombegrenzenden Element (R) und einem elektronischen Schalter (T1),
**dadurch gekennzeichnet,**
**daß** eine Steuerschaltung (ST) vorgesehen ist, welcher als Eingangsgrößen ein Steuersignal (st) für Beginn, Dauer und Ende eines Ansteuervorgangs und die Meßgrößen des dem Stellglied (P) zugeführten Stromes (i) und der am Stellglied. (P) abgreifbaren Spannung (u) zugeführt werden, und welche den Schalter (T1) mit dem Beginn eines Steuersignals (st) leitend steuert,
**daß** die Steuerschaltung (ST)
ein Multiplizierglied (X) enthält, in welchem die Meßgrößen Strom (i) und Spannun g (u) miteinander multipliziert werden,
einen Integrator (I) enthält, welcher das Produkt (p = ui) integriert (e = ∫uidt),
einen Komparator (K) enthält, welcher den Integralwert (e) mit einem vorgegebenen Sollwert (G) vergleicht, und
den Schalter (T1) nichtleitend steuert, wenn der Integralwert (e) den Sollwert (G) erreicht oder übersteigt.

4. Vorrichtung zur Durchführung des Verfahrens nach Anspruch 2, mit einer zwischen dem Pluspol (+V) und dem Minuspol (GND) einer Spannungsquelle (V) angeordneten Reihenschaltung aus dem Stellglied (P) und einem elektronischen Schalter (T1),
**dadurch gekennzeichnet,**
**daß** im Ladestromkreis des Stellgliedes (P) eine Konstantstromquelle (Q) vorgesehen ist,
**daß** eine Steuerschaltung (ST) vorgesehen ist, welcher als Eingangsgrößen ein Steuersignal (st) für Beginn, Dauer und Ende eines Ansteuervorgangs und die Meßgröße der am Stellglied (P) abgreifbaren Spannung (u) zugeführt werden, und welche den Schalter (T1) mit dem Beginn eines Steuersignals (st) leitend steuert,
**daß** die Steuerschaltung (ST)
einen Integrator (I) enthält, welcher die Meßgröße (u) integriert (e = ∫udt),
einen Komparator (K) enthält, welcher den Integralwert (e) mit einem vorgegebenen Sollwert (G) vergleicht, und
den Schalter (T1) nichtleitend steuert, wenn der Integralwert (e) den Sollwert (G) erreicht oder übersteigt.

5. Vorrichtung zur Durchführung des Verfahrens nach Anspruch 3 oder 4,
**dadurch gekennzeichnet,**
**daß** der Integrator (I) von der Einschaltflanke (st') jedes Steuersignals (st) entladen wird.

## Claims

1. Method for controlling a capacitive actuator (P), in particular a piezoelectrically driven fuel injection valve of an internal combustion engine, having a defined amount of energy (e) associated with a specific actuator displacement (ds),
**characterized in that**
during the charging process of the actuator (P) from a power source (V), the current (i) flowing into the actuator (P) and the voltage (u) that can be tapped off across the actuator (P) are multiplied together,
that the product (p = ui) of current (i) and voltage (u) is integrated over time (e = ∫uidt),
and that the charging process is finished when the integral value (e) reaches or exceeds a defined estimated value (G).

2. Method for controlling a capacitive actuator (P), in particular a piezoelectrically driven fuel injection valve of an internal combustion engine, having a defined amount of energy (e) associated with a specific actuator displacement (ds),
**characterized in that**
the actuator (P) is charged with a defined constant current (i = const),
that the voltage (u) that can be tapped off across the actuator (P) is integrated over time (e = ∫udt) during the charging process,
and that the charging process is finished when the integral value (e) reaches or exceeds a defined estimated value (G).

3. Device for implementing the method according to Claim 1 having a series circuit consisting of the actuator (P), a current limiting element (R) and an electronic switch (T1) arranged between the positive terminal (+V) and the negative terminal (GND) of a voltage source (V),
**characterized in that**
a control circuit (ST) is provided to which are input as input parameters a control signal (st) for the start, duration and end of a control process, and the measured quantities of the current (i) fed into the actuator (P) and the voltage (u) that can be tapped off across the actuator (P), and which drives the switch (T1) on (conducting) at the start of a control signal (st),
that the control circuit (ST)
contains a multiplier (X) in which the measured quantities current (i) and voltage (u) are multiplied together,
contains an integrator (I) which integrates the product (p = ui) (e = ∫uidt),
contains a comparator (K) which compares the integral value (e) with a defined estimated value (G), and
drives the switch (T1) off (non-conducting) when the integral value (e) reaches or exceeds the estimated value (G).

4. Device for implementing the method according to Claim 2 having a series circuit consisting of the actuator (P) and an electronic switch (T1) arranged between the positive terminal (+V) and the negative terminal (GND) of a voltage source (V),
**characterized in that**
a constant current source (Q) is provided in the charging circuit of the actuator (P),
that a control circuit (ST) is provided to which are input as input parameters a control signal (st) for the start, duration and end of a control process, and the measured quantity of the voltage (u) that
can be tapped off across the actuator (P), and which drives the switch (T1) on (conducting) at the start of a control signal (st), that the control circuit (ST)
contains an integrator (I) which integrates the measured quantity (u) (e = ∫udt),
contains a comparator (K) which compares the integral value (e) with a defined estimated value (G), and
drives the switch (T1) off (non-conducting) when the integral value (e) reaches or exceeds the estimated value (G).

5. Device for implementing the method according to Claim 3 or 4,
**characterized in that**
the integrator (I) is discharged by the switch-on edge (st') of every control signal (st).

## Revendications

1. Procédé pour l'amorçage d'un actionneur (P) capacitif, en particulier d'une soupape d'injection de carburant, actionnée de façon piézoélectrique, d'un moteur à combustion interne, avec une quantité d'énergie (e) prédéfinie et attribuée à une course d'actionneur (ds) déterminée,
**caractérisé**
**en ce que**, pendant l'opération de charge de l'actionneur (P) à partir d'une source d'énergie (V), le courant (i) circulant dans l'actionneur (P) et la tension (u) pouvant être prélevée sur l'actionneur (P) sont multipliés entre eux,
**en ce que** le produit (p = ui) du courant (i) et de la tension (u) en fonction du temps est intégré (e = ∫uidt), et
**en ce que** l'opération de charge est terminée lorsque la valeur intégrale (e) atteint ou dépasse une valeur de consigne (G) prédéfinie.

2. Procédé pour l'amorçage d'un actionneur (P) capacitif, en particulier d'une soupape d'injection de carburant, actionnée de façon piézoélectrique, d'un moteur à combustion interne, avec une quantité d'énergie (e) prédéfinie et attribuée à une course d'actionneur (ds) définie,
**caractérisé**
**en ce que** l'actionneur (P) est chargé avec un courant constant (i = const) prédéfini,
**en ce que** la tension (u) pouvant être prélevée sur l'actionneur (P) est intégrée pendant l'opération de charge par rapport au temps (e = ∫uidt), et
**en ce que** l'opération de charge est terminée lorsque la valeur intégrale (e) atteint ou dépasse une valeur de consigne (G) prédéfinie.

3. Dispositif pour la mise en oeuvre du procédé selon la revendication 1, avec un montage en série disposé entre le pôle plus (+V) et le pôle moins (GND) d'une source de tension (V) et constitué de l'actionneur (P), d'un élément (R) limitant le courant et d'un commutateur (T1) électronique,
**caractérisé**
**en ce qu'**il est prévu un circuit de commande (ST) auquel sont amenés en tant que grandeurs d'entrée un signal de commande (st) pour le début, la durée et la fin d'une opération d'amorçage et les grandeurs de mesure du courant (i) amené à l'actionneur (P) et de la tension (u) pouvant être prélevée sur l'actionneur (P), et qui commande le commutateur (T1) de façon conductrice avec le début d'un signal de commande (st),
**en ce que** le circuit de commande (ST)
contient un élément multiplicateur (X), dans lequel les grandeurs de mesure du courant (i) et la tension (u) sont multipliées entre elles,
contient un intégrateur (I) qui intègre le produit (p = ui) (e = ∫uidt),
contient un comparateur (K) qui compare la valeur intégrale (e) avec une valeur de consigne (G) prédéfinie, et
commande le commutateur (T1) de façon non conductrice lorsque la valeur intégrale (e) atteint ou dépasse la valeur de consigne (G).

4. Dispositif pour la mise en oeuvre du procédé selon la revendication 2, avec un montage en série disposé entre le pôle plus (+V) et le pôle négatif (GND) d'une source de tension (V) et constitué de l'actionneur (P) et d'un commutateur (T1) électronique, **caractérisé**
**en ce qu'**une source de courant constant (Q) est prévue dans le circuit de charge de l'actionneur (P),
**en ce qu'**il est prévu un circuit de commande (ST) auquel sont amenés en tant que grandeurs d'entrée un signal de commande (st) pour le début, la durée et la fin d'une opération d'amorçage et la grandeur de mesure de la tension (u) pouvant être prélevée sur l'actionneur (P), et qui commande le commutateur (T1) de façon conductrice avec le début d'un signal de commande (st),
**en ce que** le circuit de commande (ST)
contient un intégrateur (I) qui intègre la grandeur de mesure (u) (e = ∫uidt),
contient un comparateur (K) qui compare la valeur intégrale (e) avec une valeur de consigne (G) prédéfinie, et
commande l'interrupteur (T1) de façon non conductrice lorsque la valeur intégrale (e) atteint ou dépasse la valeur de consigne (G).

5. Dispositif pour la mise en oeuvre du procédé selon la revendication 3 ou 4,
**caractérisé**
**en ce que** l'intégrateur (I) est déchargé par le flanc d'enclenchement (st') de chaque signal de commande (st).
